# EUROPÄISCHE PATENTSCHRIFT

(11) **EP 3 484 633 B1**
(45) Veröffentlichungstag und Bekanntmachung des Hinweises auf die Patenterteilung: **25.12.2024**
(21) Anmeldenummer: 17731907.6
(22) Anmeldetag: 22.06.2017
(51) Int. Cl.: B05D 5/08, B05D 1/00, C09J 7/38, C09J 7/40, C23C 16/40, C23C 16/513, H01J 37/32, H05H 1/42

(54) **REDUZIERUNG DER SEITENKANTENKLEBRIGKEIT EINER KLEBEBANDROLLE**
REDUCING THE EDGE STICKINESS OF A ROLL OF ADHESIVE TAPE
RÉDUCTION DE LA PÉGOSITÉ DES BORDS LATÉRAUX D'UN ROULEAU DE RUBAN ADHÉSIF

(30) Priorität: 15.07.2016 DE 102016212971
(43) Veröffentlichungstag der Anmeldung: 22.05.2019
(73) Patentinhaber: TESA SE, 22848 Norderstedt (DE)
(72) Erfinder: KOOPS, Arne, 23881 Neu-Lankau (DE); BENDEICH, Manuel, 22527 Hamburg (DE)
(74) Vertreter: tesa SE
(86) Internationale Anmeldenummer: PCT/EP2017/065366
(87) Internationale Veröffentlichungsnummer: WO 2018/010930

(56) Entgegenhaltungen:
- EP-A2- 1 129 791
- WO-A1-2008/095653
- WO-A2-2013/039737
- MICHAELI W ET AL: "Broad range variation in surface tension by plasma-polymerized coatings on polymethyl methacrylate", SURFACE AND COATINGS TECHNOLOGY, ELSEVIER, NL, vol. 59, no. 1-3, 1 October 1993 (1993-10-01), pages 338 - 341, XP025823809, ISSN: 0257-8972, [retrieved on 19931001], DOI: 10.1016/0257-8972(93)90108-Z

## Beschreibung

Die Erfindung betrifft ein Verfahren zur Reduzierung der Wickelspiegelklebrigkeit einer Klebebandrolle sowie eine Klebebandrolle.

Bei Klebebandrollen, insbesondere des *ACX^{plus}*-Sortiments (das *ACX^{plus}*-Sortiment der Firma tesa umfasst geschäumte Klebebänder mit acrylatbasierten Klebemassen), hat es sich als nachteilig herausgestellt, dass die Seitenkanten beim Stapeln oder bei Kontakt zu anderen Gegenständen zum Verkleben neigen. Um diesem unerwünschten Effekt entgegenzuwirken, werden typischerweise silikonisierte Seitenscheiben auf den Wickelspiegel der Rolle gelegt. Bei *ACX^{plus}* Produkten werden pro Rolle zur Sicherheit zwei Seitenscheiben eingesetzt, bei *filmic*-Produkten (übliche Klebebänder mit einer Folie als Träger auf die eine Klebemasse aufgebracht ist) reicht nur eine Seitenscheibe. Selbige verhindern gleichzeitig eine Verschmutzung durch Partikel, die sich bei Transport oder Verarbeitung an den Haftklebstoff binden. Bei Einsatz entsprechender Seitenscheiben müssen diese passend auf Rollenmaß und Verpackung konfektioniert sein. Für eine maschinelle sowie manuelle Verarbeitung ist die Seitenscheibe anschließend zu entfernen, nach Gebrauch wiederum auf den Wickelspiegel zu legen. Insgesamt bedeutet die Nutzung silikonisierter Seiteneinleger einen nicht unerheblichen Arbeitsaufwand.

Es existieren bereits verschiedene Lösungen für die Deaktivierung der Seitenkantenklebrigkeit.

Über eine Druckpuderbestäubung wird die Seitenkante behandelt, so dass aufgetragenes Talkum oder aufgetragene Glaskugeln zu einer Reduzierung der Klebkraft führen. Nachteilig wirkt sich dieses Verfahren auf die optischen Eigenschaften der Klebebandrolle aus. Zudem kommt es zu Kontamination von wenig fest haftenden Talkumpartikeln, was in zahlreichen Anwendungen unerwünscht ist. Eine Langzeitstabilität der Deaktivierung ist gleichzeitig nicht gegeben, da die aufgebrachten Partikel bei höheren Temperaturen in die Klebmasse einsinken bzw. von dieser umflossen werden.

Als weitere Lösung wird die Beschichtung der Seitenkante mit einem konventionellen Lack vorgenommen. Hier sind Prozesszeiten aufgrund der notwendigen Trocknung sehr lang. Gleichzeitig beobachtet man für große Auftragsmengen von z. B. 3 g/m² höhere Abrollkräfte. Durch Zugabe von Wasser in den Lack vermindert man die Filmbildung, so dass die Abrollkräfte auf normales Niveau reduziert werden können.

Aus der WO 2008/095653 A1 ist ein Verfahren zur Passivierung einer Kante von Haftklebebändern beschrieben, wobei die Passivierung durch physikalische oder chemische Vernetzung des Haftklebers auf der Kante oder durch den physikalischen oder chemischen Abbau der für die haftklebende Wirkung verantwortlichen Strukturen des Haftklebers erfolgt. Das wird durch Auftragen eines Vernetzers auf die Seitenkante mit nachträglicher UV- oder IR-Bestrahlung, Elektronenbestrahlung, Gammabestrahlung oder Plasmabehandlung erzielt. Als Vernetzer werden unter anderem Epoxide, Amine, Isocyanate, Peroxide oder polyfunktionelle Silane offenbart. Nachteilig ist der relativ umständliche und aufwändige Aufbau des Verfahrens.

In der EP 1 373 423 ist ein Verfahren zum Deaktivieren der Klebeschicht der Kantenfläche einer Klebebandrolle beschrieben, bei dem strahlenchemisch vernetzbare Acrylate, Acrylatoligomere und Acrylatprepolymere aufgetragen werden und mit ionisierender und elektromagnetischer Strahlung ausgehärtet werden.

In der US 2010/004 47 530 ist ein Verfahren zur Beschichtung der Seitenkanten einer Klebebandrolle beschrieben, bei dem ein indirektes Auftragsverfahren verwendet wird, bei dem strahlenhärtbare Lacke oder heißschmelzende Polymere zum Einsatz kommen.

In der EP 1 129 791 A2 ist ein Verfahren zur Herstellung von antiadhäsiven Beschichtungen beschrieben, bei denen die antiadhäsive Schicht mittels Niederdruckplasmapolymerisation auf das bahnförmige Material aufgebracht wird, indem das bahnförmige Material kontinuierlich durch eine Plasmazone gezogen geführt wird, in der ein Niederdruckplasma vorhanden ist. Die mittels Plasmapolymerisation geformten antiadhäsiven Beschichtungen sind insbesondere für Klebebandrückseiten und Trennmaterialien hergestellt.

Die oben genannten Verfahren eignen sich nur bedingt zur Reduzierung der Haftklebrigkeit des Wickelspiegels einer Klebebandrolle.

Die WO 2013/039737 A2 beschreibt ein Verfahren zum Reduzieren der Klebrigkeit einer Kantenfläche eines gerollten Substrats wie eine Klebebandrolle. Das Reduzieren der Klebrigkeit erfolgt unter Einsatz einer Strahlungsquelle mit einer Strahlungsleistung bei einer Wellenlänge von weniger als 200 Nanometern.

Es ist daher Aufgabe der Erfindung, ein verbessertes Verfahren zur Verfügung zu stellen, das die Haftklebrigkeit des Wickelspiegels einer Klebebandrolle reduziert, und es ist Aufgabe der Erfindung, eine Klebebandrolle mit reduzierter Haftklebrigkeit zur Verfügung zu stellen.

Hinsichtlich des Verfahrens wird die Aufgabe durch ein Verfahren mit den Merkmalen des Anspruchs 1 gelöst.

Erfindungsgemäß wird einem Atmosphärendruck-Plasmastrom ein organische polyfunktionelle Silane aufweisender Precursor zugeführt. Der mit dem Precursor angereicherte Plasmastrom wird auf einen Wickelspiegel gerichtet und der Wickelspiegel mit einer SiOx-Beschichtung überzogen. Günstigerweise wird der mit dem Precursor angereicherte Plasmastrom direkt auf den Wickelspiegel gerichtet, so dass der Wickelspiegel unmittelbar und direkt mit einer SiOx-Beschichtung überzogen wird.

Es hat sich überraschend gezeigt, dass ein Plasmabeschichtungsverfahren direkt auf den Wickelspiegel einer Klebebandrolle angewendet werden kann. Bei der Klebebandrolle handelt es sich um ein aufgewickeltes Klebeband, dessen Länge deutlich größer als dessen Breite und dessen Breite wiederum deutlich größer als dessen Dicke ist. Das Klebeband besteht in seiner einfachsten Ausführungsform aus einer einzigen, insbesondere geschäumten Klebemassenschicht. Das Klebeband weist weiterhin zumindest eine Substratbahn auf und eine auf die Substratbahn aufgebrachte Haftklebebahn. Es ist natürlich auch möglich, dass zwischen der Substrat- und der Haftklebebahn weitere Bahnen bzw. Schichten vorgesehen sind. Für die Erfindung wesentlich ist jedoch, dass beim Aufwickeln des Klebebandes auf eine Klebebandrolle die Schmalseiten der Haftklebebahn zwischen den Substratbahnen freiliegen und an anderen Gegenständen anhaften können oder Schmutz aufnehmen können. Die Stirnseite der Abfolge aufgewickelter Substratbahnen und Haftklebebahnen, die alternierend sein kann, wird als Wickelspiegel bezeichnet. Auf den Wickelspiegel wird vorzugsweise vollflächig die SiOx-Beschichtung aufgebracht. Günstigerweise ist die Beschichtung über die gesamte Ausdehnung des Wickelspiegels von konstanter Dicke. Vorzugsweise ist die Beschichtung zwischen 60 nm bis 600 nm dick, vorzugsweise liegt die Dicke zwischen 100 nm und 200 nm.

Vorzugsweise werden Klebebandrollen hergestellt, indem zunächst eine sehr breite Klebebandrolle produziert wird mit Breiten bis zu 2.000 mm, und diese breite Klebebandrolle wird dann in Klebebandrollen geschnitten. Die geschnittenen Klebebandrollen sind an ihren Wickelspiegeln besonders klebrig.

In einer Weiterbildung der Erfindung wird eine Mutterrolle quer zur Längsachse in separate Klebebandrollen zerschnitten, und die Wickelspiegel der separaten Klebebandrollen werden zunächst mit der SiOx-Beschichtung passiviert. Eine, zwei oder jede höhere Anzahl der Klebebandrollen kann dann sogar wieder jeweils abgewickelt und traversierend neu aufgewickelt werden. Bei dem traversierenden Aufwickeln handelt es sich zunächst um ein Abwickeln eines schmalen Klebebandes von einer genauso schmalen Klebebandrolle, wobei das schmale Klebeband dann auf eine deutlich längere Wickelachse traversierend aufgewickelt wird, so dass die Klebebandlagen nicht nur direkt aufeinander zum Liegen kommen, sondern zunächst nebeneinander entlang der Wickelachse aufgewickelt werden, bis eine erste Wickellage aufgewickelt ist, und dann eine zweite Wickellage in entgegengesetzter Richtung auf der Wickelachse aufgewickelt wird.

Die Erfindung wird hinsichtlich der Klebebandrolle durch eine Klebebandrolle mit den Merkmalen des Anspruchs 7 erfüllt.

Die Klebebandrolle wird vorzugsweise durch eines der oben genannten Verfahren hergestellt und zeichnet sich durch wenigstens einen, vorzugsweise genau zwei Wickelspiegel aus, auf die vollflächig eine SiOx-Beschichtung günstigerweise in einem Plasmaverfahren aufgebracht ist. Die SiOx-Beschichtung kann eine Dicke von 60 nm bis 600 nm, vorzugsweise zwischen 100 nm und 200 nm aufweisen, und sie ist vorzugsweise über die gesamte Ausdehnung des Wickelspiegels in konstanter Schichtdicke aufgebracht.

Bei den Klebebandrollen handelt es sich insbesondere um solche des *ACX^{plus}*-Sortiments der Firma tesa.

Derartige Klebebänder umfassen eine Trägerschicht, die auch als Hartphase bezeichnet wird. Die Polymerbasis der Hartphase ist bevorzugt ausgewählt aus der Gruppe bestehend aus Polyvinylchloriden (PVC), Polyethylenterephthalaten (PET), Polyurethanen, Polyolefinen, Polybutylenterephthalaten (PBT), Polycarbonaten, Polymethylmethacrylaten (PMMA), Polyvinylbutyralen (PVB), lonomeren und Mischungen aus zwei oder mehreren der vorstehend aufgeführten Polymere. Besonders bevorzugt ist die Polymerbasis der Hartphase ausgewählt aus der Gruppe bestehend aus Polyvinylchloriden, Polyethylenterephthalaten, Polyurethanen, Polyolefinen und Mischungen aus zwei oder mehreren der vorstehend aufgeführten Polymere. Die Hartphase ist im Wesentlichen eine Polymerfolie, deren Polymerbasis aus den vorstehenden Materialien ausgewählt ist. Unter einer "Polymerfolie" wird eine dünne, flächige, flexible, aufwickelbare Bahn verstanden, deren Materialbasis im Wesentlichen von einem oder mehreren Polymer(en) gebildet wird.

Unter "Polyurethanen" werden in weitgefasstem Sinne polymere Substanzen verstanden, in denen sich wiederholende Einheiten durch Urethan-Gruppierungen -NH-CO-O-miteinander verknüpft sind.

Unter "Polyolefinen" werden Polymere verstanden, die stoffmengenbezogen zu mindestens 50% Wiederholungseinheiten der allgemeinen Struktur -[-CH2-CR1 R2-]n-enthalten, worin R1 für ein Wasserstoffatom und R2 für ein Wasserstoffatom oder für eine lineare oder verzweigte, gesättigte aliphatische oder cycloaliphatische Gruppe steht. Soweit die Polymerbasis der Hartphase Polyolefine umfasst, handelt es sich bei diesen besonders bevorzugt um Polyethylene, insbesondere um Polyethylene mit ultrahoher Molmasse (UHMWPE).

Unter der "Polymerbasis" wird das Polymer beziehungsweise werden die Polymere verstanden, das/die den größten Gewichtsanteil aller in der betreffenden Schicht beziehungsweise Phase enthaltenen Polymere ausmacht/ausmachen.

Die Dicke der Hartphase beträgt insbesondere ≤ 150 µm. Bevorzugt beträgt die Dicke der Hartphase 10 bis 150 µm, besonders bevorzugt 30 bis 120 µm und insbesondere 50 bis 100 µm, beispielsweise 70 bis 85 µm. Unter der "Dicke" wird die Ausdehnung der betreffenden Schicht beziehungsweise Phase entlang der z-Ordinate eines gedachten Koordinatensystems verstanden, bei dem die durch die Maschinenrichtung und die Querrichtung zur Maschinenrichtung aufgespannte Ebene die x-y-Ebene bildet. Die Dicke wird durch Messung an mindestens fünf verschiedenen Stellen der betreffenden Schicht beziehungsweise Phase und anschließende Bildung des arithmetischen Mittels aus den erhaltenen Messergebnissen ermittelt. Die Dickenmessung der Hartphase erfolgt dabei in Einklang mit DIN EN ISO 4593.

Derartige Klebebänder können weiterhin eine Weichphase aufweisen, die einen Polymerschaum, eine viskoelastische Masse und/oder eine elastomere Masse umfassen. Die Polymerbasis der Weichphase ist bevorzugt ausgewählt aus Polyolefinen, Polyacrylaten, Polyurethanen und Mischungen aus zwei oder mehreren der vorstehend aufgeführten Polymere.

In der einfachsten Variante besteht das Klebeband nur aus einer Weichphase.

Unter einem "Polymerschaum" wird ein Gebilde aus gasgefüllten kugel- oder polyederförmigen Zellen verstanden, welche durch flüssige, halbflüssige, hochviskose oder feste Zellstege begrenzt werden; ferner ist der Hauptbestandteil der Zellstege ein Polymer oder ein Gemisch mehrerer Polymere.

Unter einer "viskoelastischen Masse" wird ein Material verstanden, das neben Merkmalen der reinen Elastizität (Zurückkehren in den Ausgangszustand nach äußerer mechanischer Einwirkung) auch Merkmale einer viskosen Flüssigkeit zeigt, beispielsweise das Auftraten innerer Reibung bei Deformation. Insbesondere werden Haftklebemassen auf Polymerbasis als viskoelastische Massen angesehen.

Unter einer "elastomeren Masse" wird ein Material verstanden, das gummielastisches Verhalten aufweist und bei 20°C wiederholt auf mindestens das Zweifache seiner Länge gedehnt werden kann und nach Aufhebung des für die Dehnung erforderlichen Zwanges sofort wieder annähernd seine Ausgangsdimension einnimmt.

Bezüglich des Verständnisses der Begriffe "Polymerbasis", "Polyurethane" und "Polyolefine" gilt das oben Gesagte. Unter "Polyacrylaten" werden Polymere verstanden, deren stoffmengenbezogene Monomerbasis zu mindestens 50% aus Acrylsäure, Methacrylsäure, Acrylsäureestern und/oder Methacrylsäureestern besteht, wobei Acrylsäureester und/oder Methacrylsäureester zumindest anteilig generell und bevorzugt zu mindestens 50% enthalten sind. Insbesondere wird unter einem "Polyacrylat" ein Polymerisat verstanden, welches durch radikalische Polymerisation von Acryl- und/oder Methylacrylmonomeren sowie gegebenenfalls weiteren, copolymerisierbaren Monomeren erhältlich ist.

Besonders bevorzugt ist die Polymerbasis der Weichphase ausgewählt aus Polyolefinen, Polyacrylaten und Mischungen aus zwei oder mehreren der vorstehend aufgeführten Polymere. Sofern Polyolefine zu der Polymerbasis der Weichphase gehören, sind diese bevorzugt ausgewählt aus Polyethylenen, Ethylen-Vinylacetat-Copolymeren (EVA) und Gemischen aus Polyethylenen und Ethylen-Vinylacetat-Copolymeren (PE/EVA-Blends). Die Polyethylene können dabei verschiedene Polyethylen-Typen sein, beispielsweise HDPE, LDPE, LLDPE, Blends aus diesen Polyethylen-Typen und/oder Gemische davon.

In einer Ausführungsform umfasst die Weichphase einen Schaum und jeweils eine ober- und unterhalb der geschäumten Schicht angeordnete Haftklebeschicht, wobei die Polymerbasis des Schaums aus einem oder mehreren Polyolefin(en) besteht und die Polymerbasis der Haftklebeschichten aus einem oder mehreren Polyacrylat(en) besteht. Besonders bevorzugt besteht die Polymerbasis des Schaums dabei aus einem oder mehreren Polyethylen(en), Ethylen-Vinylacetat-Copolymer(en) und Gemischen aus einem oder mehreren Polyethylen(en) und/oder Ethylen-Vinylacetat-Copolymer(en). Ganz besonders bevorzugt besteht die Polymerbasis des Schaums dabei aus einem oder mehreren Polyethylen(en).

Der Polyolefin-basierte Schaum selbst ist nicht oder nur sehr wenig haftklebrig. Der Verbund mit der Hartphase beziehungsweise dem Substrat wird daher vorteilhaft durch die Haftklebeschichten bewirkt. Die Schäumung des Polyolefin-basierten Ausgangsmaterials des Schaums wird bevorzugt durch zugesetztes Treibgas im Sinne einer physikalischen Schäumung und/oder durch ein chemisches Schäumungsmittel, beispielsweise durch Azodicarbonsäurediamin, hervorgerufen.

In einer weiteren Ausführungsform ist die Weichphase ein haftklebriger Polymerschaum, dessen Polymerbasis aus einem oder mehreren Polyacrylaten besteht. "Haftklebriger Schaum" bedeutet, dass der Schaum selbst eine Haftklebemasse ist und somit ein Auftrag einer zusätzlichen Haftklebeschicht nicht erforderlich ist. Dies ist vorteilhaft, weil im Herstellungsprozess weniger Schichten zusammengefügt werden müssen und das Risiko von Ablösungserscheinungen und anderen unerwünschten Phänomenen an den Schichtgrenzen sinkt.

Unter einer "Haftklebemasse" wird ein Material verstanden, dessen abgebundener Film bei Raumtemperatur in trockenem Zustand permanent klebrig und klebfähig bleibt, wobei eine Verklebung durch leichten Anpressdruck sofort auf einer Vielzahl unterschiedlicher Substrate erfolgt.

Die Polyacrylate sind bevorzugt erhältlich durch zumindest anteiliges Einpolymerisieren von funktionellen, mit Epoxidgruppen vernetzungsfähigen Monomeren. Besonders bevorzugt handelt es sich dabei um Monomere mit Säuregruppen (besonders Carbonsäure-, Sulfonsäure oder Phosphonsäuregruppen) und/oder Hydroxygruppen und/oder Säureanhydridgruppen und/oder Epoxidgruppen und/oder Amingruppen; insbesondere bevorzugt sind carbonsäuregruppenhaltige Monomere. Es ist ganz besonders vorteilhaft, wenn die Polyacrylate einpolymerisierte Acrylsäure und/oder Methacrylsäure aufweisen. All diese Gruppen weisen eine Vernetzungsfähigkeit mit Epoxidgruppen auf, wodurch die Polyacrylate vorteilhaft einer thermischen Vernetzung mit eingebrachten Epoxiden zugänglich wird.

Weitere Monomere, die als Comonomere für die Polyacrylate verwendet werden können, sind neben Acrylsäure- und/oder Methacrylsäureestern mit bis zu 30 C-Atomen beispielsweise Vinylester von bis zu 20 C-Atome enthaltenden Carbonsäuren, Vinylaromaten mit bis zu 20 C-Atomen, ethylenisch ungesättigte Nitrile, Vinylhalogenide, Vinylether von 1 bis 10 C-Atome enthaltenden Alkoholen, aliphatische Kohlenwasserstoffe mit 2 bis 8 C-Atomen und 1 oder 2 Doppelbindungen oder Mischungen dieser Monomeren.

Die Eigenschaften des betreffenden Polyacrylats lassen sich insbesondere über eine Variation der Glasübergangstemperatur des Polymers durch unterschiedliche Gewichtsanteile der einzelnen Monomere beeinflussen. Die Polyacrylate können vorzugsweise auf die folgende Monomerzusammensetzung zurückgeführt werden:
a) Acrylsäureester und/oder Methacrylsäureester der folgenden Formel

   CH₂ = C(R^{I})(COOR^{II})

   wobei R^{I} = H oder CH₃ und R^{II} ein Alkylrest mit 4 bis 14 C-Atomen ist,
b) olefinisch ungesättigte Monomere mit funktionellen Gruppen der für eine Reaktivität mit Epoxidgruppen bereits definierten Art,
c) optional weitere Acrylate und/oder Methacrylate und/oder olefinisch ungesättigte Monomere, die mit der Komponente (a) copolymerisierbar sind.

Bevorzugt beruhen die Polyacrylate auf einer Monomerenzusammensetzung, in der die Monomere der Komponente (a) mit einem Anteil von 45 bis 99 Gew.-%, die Monomere der Komponente (b) mit einem Anteil von 1 bis 15 Gew.-% und die Monomere der Komponente (c) mit einem Anteil von 0 bis 40 Gew.-% enthalten sind (die Angaben sind bezogen auf die Monomermischung für das "Basispolymer", also ohne Zusätze eventueller Additive zu dem fertigen Polymer, wie Harze etc.). In diesem Fall weist das Polymerisationsprodukt eine Glastemperatur ≤ 15 °C (DMA bei geringen Frequenzen) und haftklebende Eigenschaften auf.

Die Monomere der Komponente (a) sind insbesondere weichmachende und/oder unpolare Monomere. Vorzugsweise werden als Monomere (a) Acryl- und Methacrylsäureester mit Alkylgruppen bestehend aus 4 bis 14 C-Atomen, besonders bevorzugt 4 bis 9 C-Atomen, eingesetzt. Beispiele für derartige Monomere sind n-Butylacrylat, n-Butylmethacrylat, n-Pentylacrylat, n-Pentylmethacrylat, n-Amylacrylat, n-Hexylacrylat, n-Hexylmethacrylat, n-Heptylacrylat, n-Octylacrylat, n-Octylmethacrylat, n-Nonylacrylat, Isobutylacrylat, Isooctylacrylat, Isooctylmethacrylat, und deren verzweigte Isomere, wie zum Beispiel 2 Ethylhexylacrylat oder 2 Ethylhexylmethacrylat.

Die Monomere der Komponente (b) sind insbesondere olefinisch ungesättigte Monomere mit funktionellen Gruppen, insbesondere mit funktionellen Gruppen, die eine Reaktion mit Epoxidgruppen eingehen können.

Bevorzugt werden für die Komponente (b) Monomere mit funktionellen Gruppen eingesetzt, die ausgewählt sind aus der Gruppe umfassend: Hydroxy-, Carboxy-, Sulfonsäure- oder Phosphonsäuregruppen, Säureanhydride, Epoxide, Amine. Besonders bevorzugte Beispiele für Monomere der Komponente (b) sind Acrylsäure, Methacrylsäure, Itaconsäure, Maleinsäure, Fumarsäure, Crotonsäure, Aconitsäure, Dimethylacrylsäure, β-Acryloyloxypropionsäure, Trichloracrylsäure, Vinylessigsäure, Vinylphosphonsäure, Itaconsäure, Maleinsäureanhydrid, Hydroxyethylacrylat, Hydroxypropylacrylat, Hydroxyethylmethacrylat, Hydroxypropylmethacrylat, 6-Hydroxyhexylmethacrylat, Allylalkohol, Glycidylacrylat, Glycidylmethacrylat.

Prinzipiell können als Komponente (c) alle vinylisch funktionalisierten Verbindungen eingesetzt werden, die mit der Komponente (a) und/oder der Komponente (b) copolymerisierbar sind. Die Monomere der Komponente (c) können zur Einstellung der Eigenschaften der resultierenden Haftklebemasse dienen.

### Beispielhafte Monomere der Komponente (c) sind:

Methylacrylat, Ethylacrylat, Propylacrylat, Methylmethacrylat, Ethylmethacrylat, Benzylacrylat, Benzylmethacrylat, sec-Butylacrylat, tert-Butylacrylat, Phenylacrylat, Phenylmethacrylat, Isobornylacrylat, Isobornylmethacrylat, tert-Butylphenylacrylat, tert-Butylaphenylmethacrylat, Dodecylmethacrylat, Isodecylacrylat, Laurylacrylat, n-Undecylacrylat, Stearylacrylat, Tridecylacrylat, Behenylacrylat, Cyclohexylmethacrylat, Cyclopentylmethacrylat, Phenoxyethylacrlylat, Phenoxyethylmethacrylat, 2-Butoxyethylmethacrylat, 2-Butoxyethylacrylat, 3,3,5-Trimethylcyclohexylacrylat, 3,5-Dimethyladamantylacrylat, 4-Cumylphenylmethacrylat, Cyanoethylacrylat, Cyanoethylmethacrylat, 4-Biphenylacrylat, 4-Biphenylmethacrylat, 2-Naphthylacrylat, 2-Naphthylmethacrylat, Tetrahydrofufurylacrylat, Diethylaminoethylacrylat, Diethylaminoethylmethacrylat, Dimethylaminoethyl-acrylat, Dimethylaminoethylmethacrylat, 2-Butoxyethylacrylat, 2-Butoxy¬ethylmethacrylat, 3-Methoxyacrylsäuremethylester, 3-Methoxybutylacrylat, Phenoxyethylacrlylat, Phenoxyethylmethacrylat, 2-Phenoxyethylmethacrylat, Butyldiglykolmethacrylat, Ethylenglycolacrylat, Ethylenglycolmonomethylacrylat, Methoxy Polyethylenglykolmethacrylat 350, Methoxy Polyethylenglykolmethacrylat 500, Propylenglycolmonomethacrylat, Butoxydiethylenglykolmethacrylat, Ethoxytriethylenglykolmethacrylat, Octafluoropentylacrylat, Octafluoropentylmethacrylat, 2,2,2-Trifluoroethylmethacrylat, 1,1,1,3,3,3-Hexafluoroisopropylacrylat, 1,1,1,3,3,3-Hexafluoroisopropylmethacrylat, 2,2,3,3,3-Pentafluoropropylmethacrylat, 2,2,3,4,4,4-Hexafluorobutylmethacrylat, 2,2,3,3,4,4,4-Heptafluorobutylacrylat, 2,2,3,3,4,4,4-Heptafluorobutylmethacrylat, 2,2,3,3,4,4,5,5,6,6,7,7,8,8,8-Pentadecafluorooctylmethacrylat, Dimethylaminopropylacrylamid, Dimethylaminopropylmethacrylamid, N-(1-Methylundecyl)acrylamid, N-(n-Butoxymethyl)acrylamid, N-(Butoxymethyl)methacrylamid, N-(Ethoxymethyl)acrylamid, N-(n-Octadecyl)acrylamid, weiterhin N,N-Dialkyl-substituierte Amide, wie beispielsweise N,N-Dimethylacrylamid, N,N-Dimethylmethacrylamid, N-Benzyl-acrylamide, N-Isopropylacrylamid, N-tert-Butylacrylamid, N-tert-Octylacrylamid, N-Methylolacrylamid, N-Methylolmethacrylamid, Acrylnitril, Methacrylnitril, Vinylether, wie Vinylmethylether, Ethylvinylether, Vinylisobutylether, Vinylester, wie Vinylacetat, Vinylchlorid, Vinylhalogenide, Vinylidenchlorid, Vinylidenhalogenide, Vinylpyridin, 4-Vinylpyridin, N-Vinylphthalimid, N-Vinyllactam, N-Vinylpyrrolidon, Styrol, a- und p-Methylstyrol, a-Butylstyrol, 4-n-Butylstyrol, 4-n-Decylstyrol, 3,4-Dimethoxystyrol. Makromonomere wie 2-Polystyrolethylmethacrylat (Molekulargewicht M_{w} von 4000 bis 13000 g/mol), Poly(methylmethacrylat)ethylmethacrylat (M_{w} von 2000 bis 8000 g/mol).

Monomere der Komponente (c) können vorteilhaft auch derart gewählt werden, dass sie funktionelle Gruppen enthalten, die eine nachfolgende strahlenchemische Vernetzung (beispielsweise durch Elektronenstrahlen, UV) unterstützen. Geeignete copolymerisierbare Photoinitiatoren sind zum Beispiel Benzoinacrylat und acrylatfunktionalisierte Benzophenonderivate. Monomere, die eine Vernetzung durch Elektronenbestrahlung unterstützen, sind zum Beispiel Tetrahydrofufurylacrylat, N-tert-Butylacrylamid und Allylacrylat.

Die Herstellung der Polyacrylate ("Polyacrylate" wird im Rahmen der Erfindung als synonym mit "Poly(meth)acrylate" verstanden) kann nach dem Fachmann geläufigen Verfahren geschehen, insbesondere vorteilhaft durch konventionelle radikalische Polymerisationen oder kontrollierte radikalische Polymerisationen. Die Polyacrylate können durch Copolymerisation der monomeren Komponenten unter Verwendung der üblichen Polymerisationsinitiatoren sowie gegebenenfalls von Reglern hergestellt werden, wobei bei den üblichen Temperaturen in Substanz, in Emulsion, zum Beispiel in Wasser oder flüssigen Kohlenwasserstoffen, oder in Lösung polymerisiert wird.

Vorzugsweise werden die Polyacrylate durch Polymerisation der Monomere in Lösungsmitteln, insbesondere in Lösungsmitteln mit einem Siedebereich von 50 bis 150 °C, vorzugsweise von 60 bis 120 °C unter Verwendung der üblichen Mengen an Polymerisationsinitiatoren, die im allgemeinen bei 0,01 bis 5, insbesondere bei 0,1 bis 2 Gew.-% (bezogen auf das Gesamtgewicht der Monomeren) liegen, hergestellt.

Prinzipiell eignen sich alle dem Fachmann geläufigen, üblichen Initiatoren. Beispiele für Radikalquellen sind Peroxide, Hydroperoxide und Azoverbindungen, zum Beispiel Dibenzoylperoxid, Cumolhydroperoxid, Cyclohexanonperoxid, Di-t-butylperoxid, Cyclohexylsulfonylacetylperoxid, Diisopropylpercarbonat, t-Butylperoktoat, Benzpinacol. In einer sehr bevorzugten Vorgehensweise wird als radikalischer Initiator 2,2'-Azobis(2-methylbutyronitril) (Vazo^{®} 67^{™} der Firma DuPont) oder 2,2'-Azobis(2-methylpropionitril) (2,2'-Azobisisobutyronitril; AIBN; Vazo^{®} 64^{™} der Firma DuPont) verwendet.

Als Lösungsmittel für die Herstellung der Polyacrylate kommen Alkohole wie Methanol, Ethanol, n-und iso-Propanol, n-und iso-Butanol, vorzugsweise Isopropanol und/oder Isobutanol, sowie Kohlenwasserstoffe wie Toluol und insbesondere Benzine eines Siedebereichs von 60 bis 120 °C in Frage. Ferner können Ketone wie vorzugsweise Aceton, Methylethylketon, Methylisobutylketon und Ester wie Essigsäureethylester sowie Gemische von Lösungsmitteln der genannten Art eingesetzt werden, wobei Gemische, die Isopropanol, insbesondere in Mengen von 2 bis 15 Gew.-%, bevorzugt 3 bis 10 Gew.-%, bezogen auf das eingesetzte Lösungsmittelgemisch, enthalten, vorgezogen werden.

Bevorzugt erfolgt nach der Herstellung (Polymerisation) der Polyacrylate eine Aufkonzentration, und die weitere Verarbeitung der Polyacrylate erfolgt im Wesentlichen lösemittelfrei. Die Aufkonzentration des Polymerisats kann in Abwesenheit von Vernetzer- und Beschleunigersubstanzen geschehen. Es ist aber auch möglich, eine dieser Verbindungsklassen dem Polymerisat bereits vor der Aufkonzentration zuzusetzen, so dass die Aufkonzentration dann in Gegenwart dieser Substanz(en) erfolgt.

Die Polymerisate können nach dem Aufkonzentrationsschritt in einen Compounder überführt werden. Gegebenenfalls können die Aufkonzentration und die Compoundierung auch im selben Reaktor stattfinden.

Die gewichtsmittleren Molekulargewichte M_{W} der Polyacrylate liegen bevorzugt in einem Bereich von 20.000 bis 2.000.000 g/mol; sehr bevorzugt in einem Bereich von 100.000 bis 1.000.000 g/mol, äußerst bevorzugt in einem Bereich von 150.000 bis 500.000 g/mol (die Angaben des mittleren Molekulargewichtes M_{W} und der Polydisperistät PD in dieser Schrift beziehen sich auf die Bestimmung per Gelpermeationschromatographie. Als Eluent wurde THF mit 0,1 Vol.-% Trifluoressigsäure eingesetzt. Die Messung erfolgte bei 25 °C. Als Vorsäule wurde PSS-SDV, 5 µm, 10³ Ä, ID 8,0 mm × 50 mm verwendet. Zur Auftrennung wurden die Säulen PSS-SDV, 5 µm, 10³ Ä, 10⁵ Ä und 10⁶ Ä mit jeweils ID 8,0 mm × 300 mm eingesetzt. Die Probenkonzentration betrug 4 g/l, die Durchflussmenge 1,0 ml pro Minute. Es wurde gegen PMMA-Standards gemessen.

Das gewichtsmittlere Molekulargewicht M_{w} wird dabei mittels Gelpermeationschromatographie (GPC) bestimmt. Als Eluent wird THF mit 0,1 Vol.-% Trifluoressigsäure eingesetzt. Die Messung erfolgt bei 25 °C. Als Vorsäule wird PSS-SDV, 5 µ, 10³ Ä, ID 8,0 mm × 50 mm verwendet. Zur Auftrennung werden die Säulen PSS-SDV, 5 µ, 10³ Ä sowie 10⁵ Å und 10⁶ Å mit jeweils ID 8,0 mm × 300 mm eingesetzt. Die Probenkonzentration beträgt 4 g/l, die Durchflussmenge 1,0 ml pro Minute. Es wird gegen PMMA Standards gemessen. (µ = µm; 1 Å = 10⁻¹⁰ m).). Dazu kann es vorteilhaft sein, die Polymerisation in Gegenwart geeigneter Polymerisationsregler wie Thiole, Halogenverbindungen und/oder Alkohole durchzuführen, um das gewünschte mittlere Molekulargewicht einzustellen).

Das Polyacrylat hat vorzugsweise einen K-Wert von 30 bis 90, besonders bevorzugt von 40 bis 70, gemessen in Toluol (1%ige Lösung, 21 °C). Der K-Wert nach Fikentscher ist ein Maß für das Molekulargewicht und die Viskosität des Polymerisats.

Besonders geeignet sind Polyacrylate, die eine enge Molekulargewichtsverteilung (Polydispersität PD < 4) haben. Diese Massen haben trotz eines relativ niedrigen Molekulargewichts nach dem Vernetzen eine besonders gute Scherfestigkeit. Zudem ermöglicht die niedrigere Polydispersität eine leichtere Verarbeitung aus der Schmelze, da die Fließviskosität gegenüber einem breiter verteilten Polyacrylat bei weitgehend gleichen Anwendungseigenschaften geringer ist. Eng verteilte Poly(meth)acrylate können vorteilhaft durch anionische Polymerisation oder durch kontrollierte radikalische Polymerisationsmethoden hergestellt werden, wobei letzteres besonders gut geeignet ist. Beispiele für derartige Polyacrylate, die nach dem RAFT-Verfahren hergestellt werden, sind in der US 6,765,078 B2 und US 6,720,399 B2 beschrieben. Auch über N-Oxyle lassen sich entsprechende Polyacrylate herstellen, wie beispielsweise in der EP 1 311 555 B1 beschrieben ist. Auch die Atom Transfer Radical Polymerization (ATRP) lässt sich in vorteilhafter Weise zur Synthese eng verteilter Polyacrylate einsetzen, wobei als Initiator bevorzugt monofunktionelle oder difunktionelle sekundäre oder tertiäre Halogenide und zur Abstraktion des(r) Halogenids(e) Cu-, Ni-, Fe-, Pd-, Pt-, Ru-, Os-, Rh-, Co-, Ir-, Ag- oder Au-Komplexe eingesetzt werden. Die unterschiedlichen Möglichkeiten der ATRP sind in den Schriften US 5,945,491 A, US 5,854,364 A und US 5,789,487 A beschrieben.

Die Monomere zur Herstellung der Polyacrylate enthalten bevorzugt anteilig funktionelle Gruppen, die geeignet sind, mit Epoxidgruppen Verknüpfungsreaktionen einzugehen. Dies ermöglicht vorteilhaft eine thermische Vernetzung der Polyacrylate durch Reaktion mit Epoxiden. Unter Verknüpfungsreaktionen werden insbesondere Additions- und Substitutionsreaktionen verstanden. Bevorzugt kommt es also zu einer Verknüpfung der die funktionellen Gruppen tragenden Bausteine mit Epoxidgruppen tragenden Bausteinen, insbesondere im Sinne einer Vernetzung der die funktionellen Gruppen tragenden Polymerbausteine über Epoxidgruppen tragende Vernetzermoleküle als Verknüpfungsbrücken. Bei den epoxidgruppenhaltigen Substanzen handelt es sich bevorzugt um multifunktionelle Epoxide, also solche mit mindestens zwei Epoxidgruppen; entsprechend kommt es bevorzugt insgesamt zu einer mittelbaren Verknüpfung der die funktionellen Gruppen tragenden Bausteine.

Das Polyacrylat beziehungsweise die Polyacrylate sind bevorzugt durch Verknüpfungsreaktionen - insbesondere im Sinne von Additions- oder Substitutionsreaktionen - von in ihnen enthaltenen funktionellen Gruppen mit thermischen Vernetzern vernetzt. Es können alle thermischen Vernetzer verwendet werden, die sowohl eine ausreichend lange Verarbeitungszeit gewährleisten, sodass es nicht zu einer Vergelung während des Verarbeitungsprozesses kommt, als auch zu einer schnellen Nachvernetzung des Polymers auf den gewünschten Vernetzungsgrad bei niedrigeren Temperaturen als der Verarbeitungstemperatur, insbesondere bei Raumtemperatur, führen. Möglich ist beispielsweise eine Kombination aus Carboxyl-, Amin- und/oder Hydroxygruppen enthaltenden Polymeren und Isocyanten als Vernetzer, insbesondere den in der EP 1 791 922 A1 beschriebenen aliphatischen oder mit Aminen deaktivierten trimerisierten Isocyanaten.

Geeignete Isocyanate sind insbesondere trimerisierte Derivate von MDI [4,4-Methylen-di(phenylisocyanat)], HDI [Hexamethylendiisocyanat, 1,6-Hexylendiisocyanat] und/oder IPDI [Isophorondiisocyanat, 5-Isocyanato-1-isocyanatomethyl-1,3,3-trimethylcyclohexan], beispielsweise die Typen Desmodur^{®} N3600 und XP2410 (jeweils BAYER AG: Aliphatische Polyisocyanate, niedrigviskose HDI-Trimerisate). Ebenfalls geeignet ist die oberflächendeaktivierte Dispersion von mikronisiertem trimerisiertem IPDI BUEJ 339^{®}, jetzt HF9 ^{®} (BAYER AG).

Grundsätzlich zur Vernetzung geeignet sind aber auch andere Isocyanate wie Desmodur VL 50 (Polyisocyanate am MDI-Basis, Bayer AG), Basonat F200WD (aliphatisches Polyisocyanat, BASF AG), Basonat HW100 (wasseremulgierbares polyfunktionelles Isocyanat auf HDI-Basis, BASF AG), Basonat HA 300 (allophanatmodifiziertes Polyisocyanat auf Isocyanurat/HDI-Basis, BASF) oder Bayhydur VPLS2150/1 (hydrophil modifiziertes IPDI, Bayer AG).

Bevorzugt wird der thermische Vernetzer, beispielsweise das trimerisierte Isocyanat, zu 0,1 bis 5 Gew.-%, insbesondere zu 0,2 bis 1 Gew.-%, bezogen auf die Gesamtmenge des zu vernetzenden Polymers, eingesetzt.

Bevorzugt umfasst der thermische Vernetzer mindestens eine epoxidgruppenhaltige Substanz. Bei den epoxidgruppenhaltigen Substanzen handelt es sich insbesondere um multifunktionelle Epoxide, also solche mit zumindest zwei Epoxidgruppen; entsprechend kommt es insgesamt zu einer mittelbaren Verknüpfung der die funktionellen Gruppen tragenden Bausteine. Die epoxidgruppenhaltigen Substanzen können sowohl aromatische als auch aliphatische Verbindungen sein.

Hervorragend geeignete multifunktionelle Epoxide sind Oligomere des Epichlorhydrins, Epoxyether mehrwertiger Alkohole (insbesondere Ethylen-, Propylen-, und Butylenglycole, Polyglycole, Thiodiglycole, Glycerin, Pentaerythrit, Sorbit, Polyvinylalkohol, Polyallylalkohol und ähnliche), Epoxyether mehrwertiger Phenole [insbesondere Resorcin, Hydrochinon, Bis-(4-hydroxyphenyl)-methan, Bis-(4-hydroxy-3-methylphenyl)-methan, Bis-(4-hydroxy-3,5-dibromphenyl)-methan, Bis-(4-hydroxy-3,5-difluorphenyl)-methan, 1,1-Bis-(4-hydroxyphenyl)ethan, 2,2-Bis-(4-hydroxyphenyl)propan, 2,2-Bis-(4-hydroxy-3-methylphenyl)-propan, 2,2-Bis-(4-hydroxy-3-chlorphenyl)-propan, 2,2-Bis-(4-hydroxy-3,5-dichlorphenyl)-propan, 2,2-Bis-(4-hydroxy-3,5-dichlorphenyl)-propan, Bis-(4-hydroxyphenyl)-phenylmethan, Bis-(4-hydroxyphenyl)-phenylmethan, Bis-(4-hydroxyphenyl)diphenylmethan, Bis (4-hydroxyphenyl)-4'-methylphenylmethan, 1,1-Bis-(4-hydroxyphenyl)-2,2,2-trichlorethan, Bis-(4-hydroxyphenyl)-(4-chlorphenyl)-methan, 1,1-Bis-(4-hydroxyphenyl)-cyclohexan, Bis-(4-hydroxyphenyl)-cyclohexylmethan, 4,4'-Dihydroxydiphenyl, 2,2'-Dihydroxydiphenyl, 4,4'-Dihydroxydiphenylsulfon] sowie deren Hydroxyethylether, Phenol-Formaldehyd-Kondensationsprodukte, wie Phenolalkohole, Phenolaldehydharze und ähnliche, S- und N-haltige Epoxide (zum Beispiel N,N-Diglycidylanillin, N,N'-Dimethyldiglycidyl-4,4-Diaminodiphenylmethan) sowie Epoxide, welche nach üblichen Verfahren aus mehrfach ungesättigten Carbonsäuren oder einfach ungesättigten Carbonsäureresten ungesättigter Alkohole hergestellt worden sind, Glycidylester, Polyglycidylester, die durch Polymerisation oder Mischpolymerisation von Glycidylestern ungesättigter Säuren gewonnen werden können oder aus anderen sauren Verbindungen (Cyanursäure, Diglycidylsulfid, cyclischem Trimethylentrisulfon bzw. deren Derivaten und anderen) erhältlich sind.

Sehr geeignete Ether sind beispielsweise 1,4-Butandioldiglycidether, Polyglycerol-3-Glycidether, Cyclohexandimethanoldiglycidether, Glycerintriglycidether, Neopentylglykoldiglycidether, Pentaerythrittetraglycidether, 1,6-Hexandioldiglycid¬ether), PolypropylenglykoIdiglycidether, Trimethylolpropantriglycidether, Penta¬erythrittetraglycidether, Bisphenol-A-diglycidether und Bisphenol-F-diglycidether.

Besonders bevorzugt ist die Verwendung eines beispielsweise in der EP 1 978 069 A1 beschriebenen Vernetzer-Beschleuniger-Systems ("Vernetzungssystem"), um eine bessere Kontrolle sowohl über die Verarbeitungszeit, Vernetzungskinetik sowie den Vernetzungsgrad zu erhalten. Das Vernetzer-Beschleuniger-System umfasst zumindest eine epoxidgruppenhaltige Substanz als Vernetzer und zumindest eine bei einer Temperatur unterhalb der Schmelztemperatur des zu vernetzenden Polymers für Vernetzungsreaktionen mittels epoxidgruppenhaltigen Verbindungen beschleunigend wirkende Substanz als Beschleuniger.

Als Beschleuniger werden besonders bevorzugt Amine (formell als Substitutionsprodukte des Ammoniaks aufzufassen; in den folgenden Formeln sind diese Substituenten durch "R" dargestellt und umfassen insbesondere Alkyl- und/oder Arylreste und/oder andere organische Reste) eingesetzt, insbesondere bevorzugt solche Amine , die mit den Bausteinen der zu vernetzenden Polymere keine oder nur geringfüge Reaktionen eingehen.

Prinzipiell können als Beschleuniger sowohl primäre (NRH₂), sekundäre (NR₂H) als auch tertiäre Amine (NR₃) gewählt werden, selbstverständlich auch solche, die mehrere primäre und/oder sekundäre und/oder tertiäre Amingruppen aufweisen. Besonders bevorzugte Beschleuniger sind aber tertiäre Amine wie beispielweise Triethylamin, Triethylendiamin, Benzyldimethylamin, Dimethylamino-methylphenol, 2,4,6-Tris-(N,N-dimethylaminomethyl)-phenol, N,N'-Bis(3-(dimethyl-amino)propyl)harnstoff. Als Beschleuniger können vorteilhaft auch multifunktionelle Amine wie Diamine, Triamine und/oder Tetramine eingesetzt werden. Hervorragend geeignet sind zum Beispiel Diethylentriamin, Triethylentetramin, Trimethylhexamethylendiamin.

Als Beschleuniger werden darüber hinaus bevorzugt Aminoalkohole verwendet. Besonders bevorzugt werden sekundäre und/oder tertiäre Aminoalkohole eingesetzt, wobei im Falle mehrerer Aminfunktionalitäten pro Molekül bevorzugt mindestens eine, bevorzugt alle Aminfunktionalitäten sekundär und/oder tertiär sind. Als bevorzugte Aminoalkohol-Beschleuniger können Triethanolamin, N,N-Bis(2-hydroxypropyl)ethanolamin, N-Methyldiethanolamin, N-Ethyldiethanolamin, 2-Aminocyclohexanol, Bis(2-hydroxycyclohexyl)methylamin, 2-(Diisopropylamino)ethanol, 2-(Dibutylamino)ethanol, N-Butyldiethanolamin, N-Butylethanolamin, 2-[Bis(2-hydroxyethyl)amino]-2-(hydroxymethyl)-1,3-propandiol, 1-[Bis(2-hydroxyethyl)amino]-2-propanol, Triisopropanolamin, 2-(Dimethylamino)ethanol, 2-(Diethylamino)ethanol, 2-(2-Dimethylaminoethoxy)ethanol, N,N,N'-Trimethyl-N'-hydroxyethylbisaminoethylether, N,N,N'-Trimethylaminoethylethanolamin und/oder N,N,N'-Trimethylaminopropylethanolamin eingesetzt werden.

Weitere geeignete Beschleuniger sind Pyridin, Imidazole (wie beispielsweise 2-Methylimidazol) und 1,8-Diazabicyclo[5.4.0]undec-7-en. Auch cycloaliphatische Polyamine können als Beschleuniger eingesetzt werden. Geeignet sind auch Beschleuniger auf Phosphatbasis wie Phosphine und/oder Phosphoniumverbindungen, wie beispielsweise Triphenylphosphin oder Tetraphenylphosphoniumtetraphenylborat.

Weiterhin kann es vorgesehen sein, dass auch ein an sich haftklebriger Polymerschaum mit einer aus Polyacrylat(en) bestehenden Polymerbasis ober- und/oder unterseitig mit einer Haftklebemasse beschichtet ist, wobei die Polymerbasis dieser Haftklebemasse bevorzugt ebenfalls aus Polyacrylaten besteht. Es können alternativ andere beziehungsweise anders vorbehandelte Klebeschichten, also beispielsweise Haftklebeschichten und/oder hitzeaktivierbare Schichten auf der Basis anderer Polymere als Poly(meth)acrylate zu der geschäumten Schicht kaschiert werden. Geeignete Basispolymere sind Naturkautschuke, Synthesekautschuke, Acrylatblockcopolymere, Vinylaromatenblockcopolymere, insbesondere Styrolblockcopolymere, EVA, Polyolefine, Polyurethane, Polyvinylether und Silikone. Bevorzugt enthalten diese Schichten keine nennenswerten Anteile an migrierfähigen Bestandteilen, die mit dem Material der geschäumten Schicht so gut verträglich sich, dass sie in signifikanter Menge in die geschäumte Schicht diffundieren und dort die Eigenschaften verändern.

Generell kann die Weichphase des Klebebandes mindestens ein klebrig machendes Harz enthalten. Als klebrig machende Harze sind insbesondere aliphatische, aromatische und/oder alkylaromatische Kohlenwasserstoffharze, Kohlenwasserstoffharze auf Basis reiner Monomere, hydrierte Kohlenwasserstoffharze, funktionelle Kohlenwasserstoffharze sowie Naturharze einsetzbar. Bevorzugt ist das klebrig machende Harz ausgewählt aus der Gruppe umfassend Pinen-, Inden- und Kolophoniumharze, deren disproportionierte, hydrierte, polymerisierte und/oder veresterte Derivate und Salze, Terpenharze und Terpenphenolharze sowie C5-, C9- und andere Kohlenwasserstoffharze. Auch Kombinationen dieser und weiterer Harze können vorteilhaft eingesetzt werden, um die Eigenschaften der resultierenden Klebmasse wunschgemäß einzustellen. Besonders bevorzugt ist das klebrig machende Harz ausgewählt aus der Gruppe umfassend Terpenphenolharze und Kolophoniumester.

Die Weichphase des Klebebandes kann einen oder mehrere Füllstoffe enthalten. Der oder die Füllstoff(e) kann/können in einer oder in mehreren Schichten der Weichphase vorliegen.

Bevorzugt umfasst die Weichphase einen Polymerschaum, und der Polymerschaum enthält teil- oder vollexpandierte Mikroballons, insbesondere, wenn die Polymerbasis des Polymerschaums ein oder mehrere Polyacrylat(e) umfasst und ganz besonders bevorzugt, wenn die Polymerbasis des Polymerschaums aus einem oder mehreren Polyacrylat(en) besteht. Bei Mikroballons handelt es sich um elastische Hohlkugeln, die eine thermoplastische Polymerhülle aufweisen; sie werden daher auch als expandierbare polymere Mikrosphären oder als Mikrohohlkugeln bezeichnet. Diese Kugeln sind mit niedrigsiedenden Flüssigkeiten oder verflüssigtem Gas gefüllt. Als Hüllenmaterial finden insbesondere Polyacrylnitril, Polyvinyldichlorid (PVDC), Polyvinylchlorid (PVC), Polyamide oder Polyacrylate Verwendung. Als niedrigsiedende Flüssigkeit sind insbesondere niedere Alkane, beispielsweise Isobutan oder Isopentan geeignet, die als verflüssigtes Gas unter Druck in der Polymerhülle eingeschlossen sind. Durch ein physikalisches Einwirken auf die Mikroballons, beispielsweise durch eine Wärmeeinwirkung - insbesondere durch Wärmezufuhr oder -erzeugung, hervorgerufen zum Beispiel durch Ultraschall oder Mikrowellenstrahlung - erweicht einerseits die äußere Polymerhülle, gleichzeitig geht das in der Hülle befindliche flüssige Treibgas in seinen gasförmigen Zustand über. Bei einer bestimmten Paarung von Druck und Temperatur - auch als kritische Paarung bezeichnet - dehnen sich die Mikroballons irreversibel aus und expandieren dreidimensional. Die Expansion ist beendet, wenn sich der Innen- und der Außendruck ausgleichen. Da die polymere Hülle erhalten bleibt, erzielt man so einen geschlossenzelligen Schaum.

Es ist eine Vielzahl an Mikroballontypen kommerziell erhältlich, wie zum Beispiel von der Firma Akzo Nobel die Expancel DU-Typen (dry unexpanded), welche sich im Wesentlichen über ihre Größe (6 bis 45 µm Durchmesser im unexpandierten Zustand) und ihre zur Expansion benötigte Starttemperatur (75°C bis 220°C) differenzieren.

Weiterhin sind unexpandierte Mikroballontypen auch als wässrige Dispersion mit einem Feststoff- beziehungsweise Mikroballonanteil von ca. 40 bis 45 Gew.-% erhältlich, darüber hinaus auch als polymergebundende Mikroballons (Masterbatche), zum Beispiel in Ethylen-Vinylacetat mit einer Mikroballonkonzentration von ca. 65 Gew.-%. Ferner sind sogenannte Mikroballon-Slurry-Systeme erhältlich, bei denen die Mikroballons mit einem Feststoffanteil von 60 bis 80 Gew.-% als wässrige Dispersion vorliegen. Sowohl die Mikroballon-Dispersionen, die Mikroballon-Slurrys als auch die Masterbatche sind wie die DU-Typen zur Schäumung eines in der Weichphase des Klebebandes enthaltenen Polymerschaums geeignet.

Besonders bevorzugt enthält der Polymerschaum Mikroballons, die im nicht expandierten Zustand bei 25 °C einen Durchmesser von 3 µm bis 40 µm, insbesondere von 5 µm bis 20 µm, und/oder nach Expansion einen Durchmesser von 10 µm bis 200 µm, insbesondere von 15 µm bis 90 µm, aufweisen.

Bevorzugt enthält der Polymerschaum bis zu 30 Gew.-% Mikroballons, insbesondere zwischen 0,5 Gew.-% und 10 Gew.-%, jeweils bezogen auf die Gesamtmasse des Polymerschaums.

Der Polymerschaum der Weichphase des Klebebandes - sofern diese einen Polymerschaum umfasst - ist bevorzugt gekennzeichnet durch die weitgehende Abwesenheit von offenzelligen Hohlräumen. Besonders bevorzugt weist der Polymerschaum einen Anteil von Hohlräumen ohne eigene Polymerhülle, also von offenzelligen Kavernen, von nicht mehr als 2 Vol-% auf, insbesondere von nicht mehr als 0,5 Vol.-%. Der Polymerschaum ist somit bevorzugt ein geschlossenzelliger Schaum.

Optional kann die Weichphase des Klebebandes auch pulver- und/oder granulatförmige Füllstoffe, Farbstoffe und Pigmente, insbesondere auch abrasive und verstärkende Füllstoffe wie zum Beispiel Kreiden (CaCO3), Titandioxide, Zinkoxide und Ruße auch zu hohen Anteilen, das heißt von 0,1 bis 50 Gew.-%, bezogen auf die Gesamtmasse der Weichphase, enthalten.

Weiterhin können schwerentflammbare Füllstoffe wie beispielsweise Ammoniumpolyphosphat; elektrisch leitfähige Füllstoffe wie beispielsweise Leitruß, Kohlenstofffasern und/oder silberbeschichtete Kugeln; thermisch leitfähige Materialien wie beispielsweise Bornitrid, Aluminiumoxid, Siliciumcarbid; ferromagnetische Additive wie beispielsweise Eisen-(III)-oxide; weitere Additive zur Volumenerhöhung, wie beispielsweise Blähmittel, Glasvollkugeln, Glashohlkugeln, carbonisierte Mikrokugeln, phenolische Mikrohohlkugeln, Mikrokugeln aus anderen Materialien; Kieselsäure, Silicate, organisch nachwachsende Rohstoffe wie beispielsweise Holzmehl, organische und/oder anorganische Nanopartikel, Fasern; Alterungsschutzmittel, Lichtschutzmittel, Ozonschutzmittel und/oder Compoundierungsmittel in der Weichphase enthalten sein. Als Alterungsschutzmittel können bevorzugt sowohl primäre, z.B. 4-Methoxyphenol oder Irganox^{®} 1076, als auch sekundäre Alterungsschutzmittel, z.B. Irgafos^{®} TNPP oder Irgafos^{®} 168 der Firma BASF, gegebenenfalls auch in Kombination miteinander, eingesetzt werden. Als weitere Alterungsschutzmittel können Phenothiazin (C-Radikalfänger) sowie Hydrochinonmethylether in Gegenwart von Sauerstoff sowie Sauerstoff selbst eingesetzt werden.

Die Dicke der Weichphase beträgt vorzugsweise 200 bis 1800 µm, besonders bevorzugt 300 bis 1500 µm, insbesondere 400 bis 1000 µm. Die Dicke der Weichphase wird nach ISO 1923 bestimmt.

Die Verbindung von Hart- und Weichphase beziehungsweise auch von in der Hart- und/oder Weichphase vorgesehenen Schichten untereinander zum Klebeband kann beispielsweise durch Laminieren, Kaschieren oder Coextrusion erfolgen. Es ist möglich, dass Hart- und Weichphase direkt, das heißt unmittelbar, miteinander verbunden sind. Ebenso ist es möglich, dass zwischen Hart- und Weichphase eine oder mehrere haftvermittelnde Schicht(en) angeordnet ist/sind. Das Klebeband kann darüber hinaus weitere Schichten enthalten.

Bevorzugt ist mindestens eine der miteinander zu verbindenden Schichten, stärker bevorzugt sind mehrere der miteinander zu verbindenden Schichten und ganz besonders bevorzugt sind alle der miteinander zu verbindenden Schichten mit Corona- (mit Luft oder Stickstoff), Plasma- (Luft, Stickstoff oder andere reaktive Gase beziehungsweise reaktive, als Aerosol einsetzbare Verbindungen) oder Flammenvorbehandlungsmethoden vorbehandelt.

Auf der Rückseite, das heißt auf der vom Substrat abgewandten Seite der Hartphase, ist bevorzugt eine Funktionsschicht aufgebracht, die beispielsweise Trenneigenschaften oder UV-stabilisierende Eigenschaften aufweist. Diese Funktionsschicht besteht bevorzugt aus einer Folie mit einer Dicke von ≤ 20 µm, besonders bevorzugt von ≤ 10 µm, insbesondere von ≤ 8 µm, beispielsweise von ≤ 5 µm oder einem Lack mit einer Dicke von ≤ 10 µm, besonders bevorzugt von ≤ 6 µm, insbesondere von ≤ 3 µm, beispielsweise von ≤ 1,5 µm. Sowohl die Folie als auch der Lack enthalten bevorzugt einen UV-Absorber, und/oder die Polymerbasis der Folie beziehungsweise des Lacks enthält UV-absorbierende und/oder UV-abweisende Gruppen.

Folien können durch Laminieren, Kaschieren oder Coextrusion auf die Rückseite der Hartphase aufgebracht werden. Bei der Folie handelt es sich bevorzugt um eine metallisierte Folie. Die Polymerbasis der Folie ist bevorzugt ausgewählt aus der Gruppe bestehend aus Polyarylenen, Polyvinylchloriden (PVC), Polyethylenterephthalaten (PET), Polyurethanen, Polyolefinen, Polyutylenterephthalaten (PBT), Polycarbonaten, Polymethylmethacrylaten (PMMA), Polyvinylbutyralen (PVB), lonomeren und Mischungen aus zwei oder mehreren der vorstehend aufgeführten Polymere. "Hauptbestandteil" bedeutet hier "Bestandteil mit dem größten Gewichtsanteil, bezogen auf das Gesamtgewicht der Folie". Mit Ausnahme der Polyarylene weisen alle aufgeführten Materialien der Folie bevorzugt einen hohen Gehalt an UV-Stabilisatoren auf.

In einer speziellen Ausführungsform besteht das Klebeband in auf das Substrat gerichteter Reihenfolge aus einer Funktionsschicht (wie vorstehend beschrieben); einer Hartphase und einer Weichphase bestehend aus einer Haftklebeschicht, einem Polymerschaum, dessen Polymerbasis aus einem oder mehreren Polyolefinen besteht, und einer weiteren Haftklebeschicht. Die untere Haftklebeschicht kann mit einem Releaseliner abgedeckt sein, dieser wird jedoch nicht zum Klebeband gerechnet.

In einer weiteren speziellen Ausführungsform besteht das Klebeband in auf das Substrat gerichteter Reihenfolge aus einer Funktionsschicht (wie vorstehend beschrieben); einer Hartphase und einer haftklebrigen Weichphase, deren Polymerbasis aus einem oder mehreren Polyacrylaten besteht. Auch bei dieser Ausführungsform kann die Unterseite, das heißt die dem Substrat zugewandte Seite, der Weichphase mit einem Releaseliner abgedeckt sein, dieser wird jedoch nicht zum Klebeband gerechnet.

Bevorzugt handelt es sich bei den Klebebändern um geschäumte Acrylatmassen insbesondere der oben beschriebenen Art, die zusätzlich einen (oder mehrere) Zwischenträger haben können.

Besonders vorteilhaft kann das erfindungsgemäße Verfahren zur Reduzierung der Wickelspiegelklebrigkeit einer Klebebandrolle zum Einsatz kommen, wenn der Wickelspiegel der Klebebandrolle kontaminiert ist.

Eine solche Kontamination des Wickelspiegels ergibt sich oftmals während des Schneidvorgangs, insbesondere wenn einzelne Klebebandrollen in tellerform von einer Mutterrolle abgestochen werden. Zum Schneiden werden dann Schneidhilfsmittel verwendet, zum Beispiel Öle oder Wasser. Die Schneidhilfsmittel finden sich auf den Wickelspiegeln wieder.

Klebebänder werden hergestellt, indem üblicherweise eine breite Rolle Trägermaterial abgerollt wird und anschließend mit einer Klebemasse ausgerüstet wird. Diese Klebemasse kann anschließend mit einem Liner eingedeckt werden. Nach eventuellen weiteren Verarbeitungsschritten wie zum Beispiel Trocknen wird das mit Klebemasse ausgerüstete Trägermaterial, Klebebandbahn genannt, samt Liner zu einer so genannten Mutterrolle aufgewickelt. Zum Schneiden wird die Mutterrolle abgewickelt und die mit einem Liner eingedeckte Klebebandbahn einer entsprechenden Schneidvorrichtung zugeführt, in der die Klebebandbahn in einzelne Klebebänder aufgeschnitten wird, die dann üblicherweise auf Kerne aus beispielsweise Pappe oder Kunststoff gewickelt werden. Das Schneiden kann auch direkt nach der Fertigung erfolgen, also ohne dass die Klebebandbahn samt Liner auf- und wieder abgewickelt wird.

Daneben werden Klebebänder dadurch hergestellt, dass aus einer Jumbo- oder Mutterrolle direkt Klebebandrollen abgestochen werden.

Weiterhin ist es möglich, dass die Klebebandbahn ohne Liner geschnitten wird und der Liner nach dem Schnittvorgang in der entsprechenden Breite auf die offene Klebemassenseite aufgebracht wird.

Ein einschlägiger Abstechautomat ist beispielsweise in der EP 1 436 112 A1 beschrieben.

Überraschenderweise ist ein kontaminierter Wickelspiegel in gleicher Qualität wie ein nichtkontaminierter Wickelspiegel passivierbar.

Die Erfindung wird anhand eines Ausführungsbeispiels in zwei Figuren beschrieben, dabei zeigen:
- Fig. 1: einen prinzipiellen Aufbau einer verwendeten Plasmadüse,
- Fig. 2: einen mit einer SiOx-Beschichtung versehenen Wickelspiegel einer Klebebandrolle.

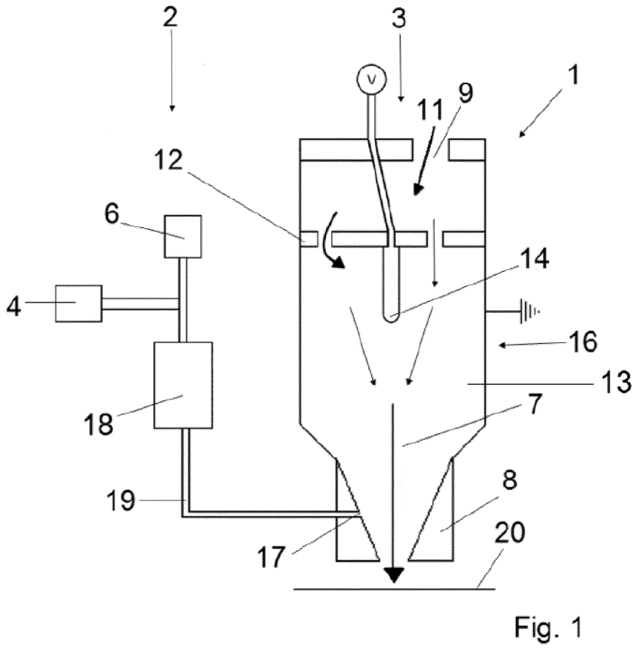

Fig. 1 zeigt die prinzipielle Ansicht einer Plasmadüse 1, dabei handelt es sich um ein OpenAir-System der *Plasmatreat* GmbH.

Die Plasmadüse 1 umfasst eine Precursoreinheit 2, die in der Fig. 1 links dargestellt ist und eine Plasmaeinheit 3. Die Precursoreinheit 2 erzeugt ein mit einem Precursor 4 angereichertes Trägergas 6, während die Plasmaeinheit 3 ein Plasma 7 erzeugt. Der Precusor 4 und das Plasma 7 werden in einem Düsenkopf 8 zusammengeführt.

Unter dem Plasma 7 wird hier ein hochenergetisches Prozessgas 11, insbesondere ein angeregtes und ionisiertes Luft-Stickstoff-Gemisch verstanden. Zur Erzeugung wird zunächst der Plasmaeinheit 3 durch einen Einlass 9 das Prozessgas 11 zugeführt, bei dem Prozessgas 11 handelt es sich hier um Luft oder Stickstoff oder ein Gemisch daraus. Das Prozessgas 11 wird durch den Einlass 9 in die Plasmaeinheit 3 eingeleitet und gelangt durch eine Blende 12 mit Bohrungen in eine Entladungszone 13, durch die das Prozessgas 11 hindurchströmt. In der Entladungszone 13 wird das Prozessgas 11 an einer Elektrodenspitze 14 vorbeigeführt, an der eine hochfrequente Wechselspannung mit einigen Kilovolt und einer Frequenz von 10 kHz angeschlossen ist. Zwischen der Elektrodenspitze 14 und einer Gegenelektrode, die beispielsweise ein geerdetes Edelstahlgehäuse 16 sein kann, entsteht ein starkes elektrisches Wechselfeld, das zu einer sogenannten Coronarentladung führt, die das durch die Plasmaeinheit 3 an der Elektrodenspitze 14 vorbeiströmende Prozessgas 11 ionisiert und in einen Strom des Plasmas 7 umwandelt. Das Plasma 7 wird durch den Düsenkopf 8 geführt, an dem an einem seitlichen Einlass 17 die Precursoreinheit 2 angeschlossen ist.

Der seitliche Einlass 17 des Düsenkopfes 8 ist mit der Precursoreinheit 2 verbunden. Die Precursoreinheit 2 umfasst eine erste Zufuhr für den Precursor 4 und eine zweite Zufuhr für das Trägergas 6. Als Trägergas 6 kann hier ebenfalls Luft oder Stickstoff oder ein Gemisch aus Luft und Stickstoff verwendet werden. Der Precursor 4 wird zerstäubt und dem Trägergas 6 tröpfchenförmig zugeführt, das Gemisch gelangt in einen Verdampfer 18, wo Temperaturen oberhalb des Siedepunktes des Precursors 4 herrschen. Als Precursor 4 kann ein organisches polyfunktionelles Silan verwendet werden, beispielsweise Octyltriethoxysilan (OCS), (3-Glycidyloxypropyl)trimethoxysilane (GLYMO) und Hexamethyldisiloxan (HMDSO).

Bei dem hier verwendeten Precursor 4 handelt es sich um Hexamethyldisiloxan (HMDSO), das dem Trägergas in einer Größenordnung von 10, 20, 40 bis zu 150 Gramm pro Stunde zugeführt wird. Die Temperatur im Verdampfer 18 liegt bei etwa 120 °C, also oberhalb der Siedetemperatur von HMDSO, die etwa bei 100 °C liegt.

Ein dem Verdampfer 18 entweichendes Precursorgas 19 wird dem Düsenkopf 8 zugeführt und dort mit dem Plasma 7 vermengt. Der Precursor 6 gelangt so mit dem Plasma 7 auf einen Wickelspiegel 20.

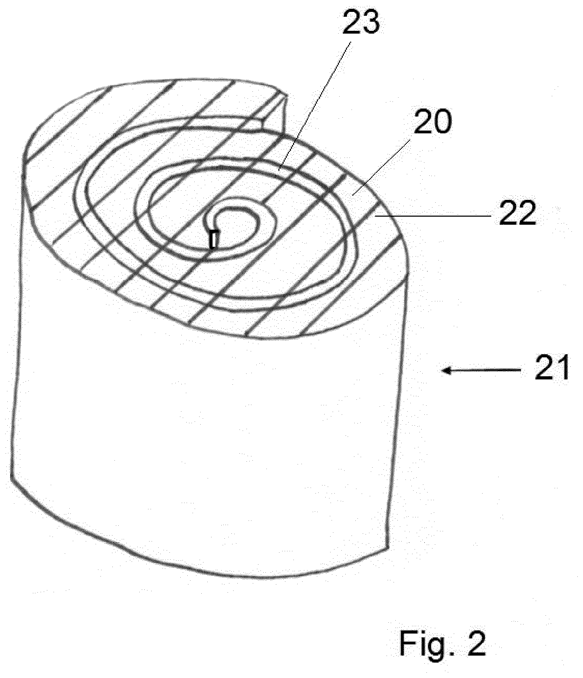

In der Fig. 2 ist eine Klebebandrolle 21 dargestellt mit einem der beiden Wickelspiegel 20. Die Klebebandrolle 21 besteht aus einem aufgerollten Klebeband, das wiederum eine Substratbahn 22 aufweist, auf die einseitig ein Haftklebstoff vollflächig als Haftklebstoffbahn 23 aufgebracht ist. Die Substratbahn 22 kann eine Folie, ein Gewebe oder ein Papier sein.

Die Substratbahn 22 und die Haftklebstoffbahn 23 bilden zusammen das Klebeband aus, das in Fig. 2 aufgerollt ist. Die Substratbahn 22 wird üblicherweise in Breiten von 500 mm bis 2.000 mm gefertigt und zur Verfügung gestellt und auch in dieser Breite mit dem Haftklebstoff beschichtet. Die Substratbahn 22 wird mit der auf ihr ausgebildeten Haftklebstoffbahn 23 zusammen aufgewickelt, so dass eine breite Klebebandrolle ebenfalls in einer Breite von 500 mm bis 2.000 mm entsteht. Erst danach wird die breite Klebebandrolle auf Klebebandrollen 21 der gewünschten Arbeitsbreite geschnitten. Nach dem Schneidvorgang liegt der Haftklebstoff der Schnittkanten der Klebebandrollen 21, insbesondere der Haftklebstoffbahnen 23, offen und kann durch seine adhäsiven Eigenschaften die Weiterverarbeitung sowie den Produkteinsatz erschweren oder sogar unmöglich machen.

Der Wickelspiegel 20 der Fig. 2 zeichnet sich durch eine alternierende Abfolge von Substratbahnen 22 und Haftklebstoffbahnen 23 aus. In Ausführungsformen der Klebebandrolle 21 weist das Klebeband ein sehr kleines Verhältnis einer Dicke der Substratbahn 22 zu einer Dicke der Haftklebstoffbahn 23 auf. Bei solchen Klebebändern, die als Dickschichtprodukte bezeichnet werden, werden häufig viskoelastische Materialien für die Substratbahnen 22 mit eigenen adhäsiven Eigenschaften eingesetzt, so dass beinahe der gesamte Wickelspiegel 20 der Klebebandrolle 21 klebend ist. Die Haftklebrigkeit des Wickelspiegels 20 führt dazu, dass nach Kontakt mit anderen Gegenständen die Klebebandrolle 21 beim Entfernen zerstört oder deformiert wird oder sie für eine Verwendung nicht mehr einsetzbar ist. Das ist insbesondere ein Problem bei Schmalrollen, die eine nur geringe mechanische Festigkeit aufweisen.

Die Haftklebrigkeit des Wickelspiegels 20 wird durch Aufbringen einer Passivierungsschicht verringert. Bei der Passivierungsschicht handelt es sich erfindungsgemäß um eine SiOx-Beschichtung, die mit Hilfe der in Fig. 1 dargestellten Plasmadüse 1 in einem Plasmaverfahren vollflächig auf den Wickelspiegel 20 aufgebracht wird.

Die Plasmadüse 1 steht in einem senkrechten Winkel zu einer Oberfläche des Wickelspiegels 20 und mündet in den Düsenkopf 8, wobei der Wickelspiegel 20 auf einem nicht dargestellten rotierenden Tisch aufliegt.

Die Behandlung des Wickelspiegels 20 findet bei oder nahe bei Atmosphärendruck statt, wobei der Druck in der elektrischen Entladungszone 13 der Plasmadüse 1 auch höher sein kann. Unter einem Plasma 7 wird in diesem Ausführungsbeispiel ein Atmosphärendruckplasma verstanden, das ein elektrisch aktiviertes homogenes reaktives Gas ist, das sich nicht im thermischen Equilibrium befindet, mit einem Druck nahe dem Umgebungsdruck in seinem Wirkbereich. Im Allgemeinen beträgt der Druck 0,5 bar mehr als der Umgebungsdruck. Durch die elektrischen Entladungen oder durch die lonisierungsprozesse im elektrischen Feld der Entladungszone 13 wird das Prozessgas 11 aktiviert, und es werden hochangeregte Zustände in den Gasbestandteilen erzeugt. Dem Prozessgas 11 wird dann in dem Düsenkopf 8 über einen gasleitenden Kanal über den seitlichen Einlass 17 der Precursor 4 in Gasform oder als Aerosol zugeführt, der die eigentliche Siliciumoxidschicht auf der Oberfläche des Wickelspiegels 20 ausbildet.

### Beispiel 1:

In diesem Beispiel wird dem Prozessgas 11 Hexamethyldisiloxan (HMDSO) als Precursor 4 zugeführt, das im Prozessgas 11 angeregt wird und seine Reaktivität dabei signifikant erhöht. Dadurch lagert sich SiOx an der Oberfläche des Wickelspiegels 20 optimal an und bindet fest an. In den vorliegenden Beispielen werden Wickelspiegel 20 von sogenannten *ACX^{plus}*-Rollen betrachtet, deren Seitenkantenklebrigkeit reduziert werden soll. Zunächst wird nicht der Wickelspiegel 20 selbst, sondern ein Lappenmuster mit Hilfe des oben beschriebenen Plasmaverfahrens behandelt. Der Versuchsaufbau umfasst folgende zu betrachtende Parameter, Bedingungen und technische Daten:

| | |
|---|---|
| Behandelndes Material: | *ACX^{plus}-* 7056 als Lappenmuster |
| Plasmadüse: | Generator FG 5001, feste Düse 216028WE |
| Precursor: | Hexamethyldisiloxan (HMDSO) |
| Precursormenge: | 10, 20, 40 g/Stunde |
| Anzahl der Behandlung: | 1- bis 3-fach |
| Behandlungsgeschwindigkeit: | 40 m/min für plane KM-Oberflächen |
| Abstand der Düse: | 15 mm |
| PCT (Pulse-Cycle-Time): | 20 % und 100 % |

Über den PCT-Wert wird die glasartige Ausprägung der Silanschicht gesteuert.

Unter PCT (Pulse-Cycle-Time) wird verstanden, dass die Plasmaentladung durch Pulse moduliert wird. Ein- und Ausschalten kann die Standzeiten der Elektrodenspitzen 14 verbessern und die Bildung der reaktiven Spezies beeinflussen. 100 Prozent entspricht dabei einer kontinuierlichen Entladung.

Tabelle 1 zeigt die Tackergebnisse von un- und behandelten *ACX^{plus}*-7056 Lappenmustern im Proptec-Standardverfahren.

Das Proptec-Verfahren ist eine Methode zur Messung der Sofortklebkraft, also der Tack einer Klebmasse. Diese kann als Qualitätsmerkmal für die Passivierung herangezogen werden und kann einen quantifizierten Wert angeben.

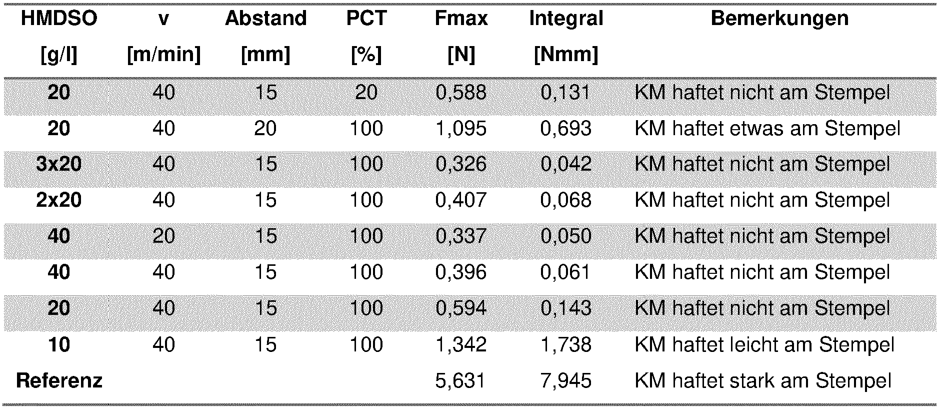

tesa^{®} *ACX^{plus}* 7056 ist ein transparentes trägerloses Acrylatklebeband mit einer geschäumten Haftklebemasse auf Acrylatbasis mit einer Dicke von 1500 µm. Dabei wird eine Klebseite eines mit *ACX^{plus}* beschichteten Lappens mit HMDSO beschichtet, wobei die linke Spalte die aufgetragene HMDSO Menge pro Stunde wiedergibt, die zweite Spalte die Geschwindigkeit, mit der der Düsenkopf 8 über den Lappen geführt wird, die dritte Spalte den Abstand des Düsenkopfes 8 vom Lappen und PCT die oben genannte Pulse-Cycle-Time. Fmax gibt die maximale Kraft an, die notwendig ist, um den auf den Lappen aufgedrückten Stempel abzuziehen, und die rechte Spalte gibt die dafür benötigte Energie an.

Die Fläche des kreisrunden Proptec-Stempels beträgt 25,4 mm, der Stempel wird mit einer Kraft von 4,5 N für 1 sec. auf den Lappen aufgepresst.

Unter der Rubrik Bemerkungen' ist aufgeführt, wie stark der Lappen (KM) am Stempel haftet. Die untere Zeile gibt die Referenz eines mit *ACX^{plus}* beschichteten Lappens ohne plasmapolymerisierte Beschichtung an. Deutlich erkennbar ist, dass gegenüber der nichtbehandelten Haftklebeoberfläche des *ACX^{plus}* Produktes deutliche Verringerungen der Haftkraft messbar sind. Bei der Haftkraft spricht man auch von Tackigkeit. Die obengenannten Messungen sind aber auch auf den Wickelspiegel 20 von *ACX^{plus}* Rollen übertragbar. Bei den behandelten *ACX^{plus}* Rollen ist festzustellen, dass diese nicht nur nicht auf metallischem Untergrund haften, sondern auch ohne Probleme wieder aufgenommen werden können. Hinzu kommt die schmutzabweisende Funktion der Plasmapolymerisationsschicht, da Staub, Fasern und Papier kaum auf dem Haftklebstoff haften bleiben. Es konnten auch während eines Zeitraums von acht Stunden keine erkennbaren Verschmutzungen der Düsenbauteile der Plasmaeinheit 3 durch den Precursor 4 festgestellt werden.

### Bezugszeichenliste

- 1: Plasmadüse
- 2: Precursoreinheit
- 3: Plasmaeinheit
- 4: Precursor

- 6: Trägergas
- 7: Plasma
- 8: Düsenkopf
- 9: Einlass

- 11: Prozessgas
- 12: Blende
- 13: Entladungszone
- 14: Elektrodenspitze

- 16: geerdetes Edelstahlgehäuse
- 17: seitlicher Einlass
- 18: Verdampfer
- 19: Precursorgas

- 20: Wickelspiegel
- 21: Klebebandrolle
- 22: Substratbahn
- 23: Haftklebstoffbahn

## Patentansprüche

1. Verfahren zur Reduzierung der Wickelspiegelklebrigkeit einer Klebebandrolle (21),
wobei das die Klebebandrolle (21) bildende Klebeband zumindest eine Substratbahn (22) und eine auf die Substratbahn (22) aufgebrachte Haftklebebahn (23) aufweist,
indem
einem Plasmastrom ein organische polyfunktionelle Silane aufweisender Precursor (4) zugeführt wird,
der mit dem Precursor (4) angereicherte Plasmastrom auf den Wickelspiegel (20) gerichtet wird und der Wickelspiegel (20) mit einer SiOx₋Beschichtung überzogen wird.

2. Verfahren nach Anspruch 1,
**dadurch gekennzeichnet, dass** als Precursor (4) ein polyfunktionelles Silan aus der Gruppe Hexamethyldisiloxan (HMDSO), (3-Glycidyloxypropyl)trimethoxysilane (GLYMO), Octyltriethoxysilan (OCS) verwendet wird.

3. Verfahren nach Anspruch 1 oder 2,
**dadurch gekennzeichnet, dass** eine Mutterrolle quer zur Längsrichtung in einzelne Klebebandrollen zerschnitten wird und die Wickelspiegel der separaten Klebebandrollen zunächst mit der SiOx-Beschichtung passiviert werden und zumindest eine der separaten Klebebandrollen (21) abgerollt wird und traversierend aufgewickelt wird.

4. Verfahren nach Anspruch 1, 2 oder 3,
**dadurch gekennzeichnet, dass** die SiOx-Beschichtung in einer Dicke zwischen 60 nm bis 600 nm aufgetragen wird.

5. Verfahren nach einem der vorstehenden Ansprüche,
**dadurch gekennzeichnet, dass** die SiOx-Beschichtung vollflächig auf den Wickelspiegel (20) aufgebracht wird.

6. Verfahren nach einem der vorstehenden Ansprüche,
**dadurch gekennzeichnet, dass** die SiOx-Beschichtung über ihre gesamte Ausdehnung eine konstante Dicke aufweist.

7. Klebebandrolle hergestellt in einem der vorgenannten Verfahren mit einem Wickelspiegel (20),
einer auf den Wickelspiegel (20) vollflächig aufgebrachten SiOx-Beschichtung.

8. Klebebandrolle nach Anspruch 7,
**dadurch gekennzeichnet, dass** die SiOx-Beschichtung eine Dicke von 60 nm bis 600 nm aufweist.

9. Klebebandrolle nach Anspruch 8,
**dadurch gekennzeichnet, dass** die SiOx Beschichtung über ihre gesamte Ausdehnung eine konstante Dicke aufweist.

10. Klebebandrolle nach zumindest einem der Ansprüche 7 bis 9,
**dadurch gekennzeichnet, dass** der Wickelspiegel der Klebebandrolle durch Schneidhilfsmittel kontaminiert ist.

## Claims

1. A method for reducing the roll end face tackiness of a roll of adhesive tape (21), wherein the adhesive tape forming the roll of adhesive tape (21) has at least one substrate web (22) and a web of pressure-sensitive adhesive (23) applied to the substrate web (22),
in which
a precursor (4) containing an organic polyfunctional silane is supplied to a stream of plasma,
the stream of plasma enriched with the precursor (4) is directed onto the roll end face (20) and the roll end face (20) is coated with a coating of SiOx.

2. The method as claimed in claim 1,
**characterized in that** a polyfunctional silane from the group: hexamethyldisiloxane (HMDSO), (3-glycidyloxypropyl)trimethoxysilane (GLYMO), octyltriethoxysilane (OCS) is used as the precursor (4) .

3. The method as claimed in claim 1 or 2,
**characterized in that** a master roll is slit into individual rolls of adhesive tape transversely to the longitudinal direction and the roll end face of the separate rolls of adhesive tape are initially passivated with the SiOx coating and at least one of the separate rolls of adhesive tape (21) is unrolled and transverse wound.

4. The method as claimed in claim 1, 2 or 3,
**characterized in that** the SiOx coating is applied with a thickness of between 60 nm to 600 nm.

5. The method as claimed in one of the preceding claims, **characterized in that** the SiOx coating is applied to the entire surface of the roll end face (20).

6. The method as claimed in one of the preceding claims, **characterized in that** the SiOx coating has a constant thickness over its entire extent.

7. A roll of adhesive tape manufactured in one of the methods defined above,
with a roll end face (20),
with a SiOx coating applied to the entire surface of the roll end face (20).

8. The roll of adhesive tape as claimed in claim 7,
**characterized in that** the SiOx coating has a thickness of 60 nm to 600 nm.

9. The roll of adhesive tape as claimed in claim 8,
**characterized in that** the SiOx coating has a constant thickness over its entire extent.

10. The roll of adhesive tape as claimed in at least one of claims 7 to 9,
**characterized in that** the roll end face of the roll of adhesive tape is contaminated with slitting aid.

## Revendications

1. Procédé permettant de réduire le caractère adhésif de la face latérale d'enroulement d'un rouleau de ruban adhésif (21), le ruban adhésif qui forme le rouleau de ruban adhésif (21) comportant au moins une bande de support (22) et une bande d'adhésif sensible à la pression (23) qui est appliquée sur lande de support (22), consistant à ajouter un précurseur (4) comportant des silanes polyfonctionnels organiques à un flux de plasma, à diriger le flux de plasma enrichi en le précurseur (4) contre la face latérale d'enroulement (20) et à recouvrir la face latérale d'enroulement (20) d'un revêtement de SiOx.

2. Procédé selon la revendication 1,
**caractérisé en ce que** l'on utilise en tant que précurseur (4) un silane polyfonctionnel issu du groupe de hexaméthyldisiloxane (HMDSO), (3-glycidyloxypropyl)triméthoxysilane (GLYMO), octyltriéthoxysilane (OCS).

3. Procédé selon les revendications 1 ou 2,
**caractérisé en ce qu'**un rouleau mère est découpé transversalement à la direction longitudinale en différents rouleaux de ruban adhésif et les faces latérales d'enroulement des rouleaux de ruban adhésif séparés sont d'abord passivées au moyen dudit revêtement de SiOx et au moins un des rouleaux de ruban adhésif (21) séparés est déroulé puis enroulé de manière traversante.

4. Procédé selon les revendications 1, 2 ou 3,
**caractérisé en ce que** le revêtement de SiOx est appliqué dans une épaisseur comprise entre 60 nm et 600 nm.

5. Procédé selon l'une des revendications précédentes, **caractérisé en ce que** le revêtement de SiOx est appliqué sur toute la surface de la face latérale d'enroulement (20) .

6. Procédé selon l'une des revendications précédentes,
**caractérisé en ce que** le revêtement de SiOx présente une épaisseurs constante sur toute son étendue.

7. Rouleau de ruban adhésif fabriqué selon l'un des procédés précédemment mentionnés, comportant une face latérale d'enroulement (20),
un revêtement de SiOx ayant été appliqué sur toute la surface de la face latérale d'enroulement (20).

8. Rouleau de ruban adhésif selon la revendication 7,
**caractérisé en ce que** le revêtement de SiOx présente une épaisseur comprise entre 60 nm et 600 nm.

9. Rouleau de ruban adhésif selon la revendication 8,
**caractérisé en ce que** le revêtement de SiOx présente une épaisseur constante sur toute son étendue.

10. Rouleau de ruban adhésif selon au moins une des revendications 7 à 9, **caractérisé en ce que** la face latérale d'enroulement du rouleau de ruban adhésif est contaminée par des moyens d'aide à la découpe.
